# EUROPÄISCHE PATENTANMELDUNG

(11) **EP 1 478 015 A2**
(43) Veröffentlichungstag der Anmeldung: **17.11.2004**
(21) Anmeldenummer: 04004428.1
(22) Anmeldetag: 26.02.2004
(51) Int. Cl.: H01L 21/60, H01L 23/29, H01L 23/485, H01L 23/31

(54) **Einzelhalbleiterelement in Flip-Chip Bauweise**

(30) Priorität: 15.05.2003 DE 10321954
(71) Anmelder: Vishay Semiconductor GmbH, 74072 Heilbronn (DE)
(72) Erfinder: Mathe, Franz, 4801 Traunkirchen (AT); Zurek, Werner, 74348 Lauffen (DE)
(74) Vertreter: Manitz, Finsterwald & Partner GbR

(57) **Zusammenfassung**

An der Rückseite (11) eines Einzelhalbleiterelements ist eine Substratschicht (13) vorgesehen. Eine aktive Schicht (15,21) ist zwischen der Substratschicht (13) und einer Kontaktierungsseite (23) des Einzelhalbleiterelements angeordnet. Wenigstens zwei Lötkontakte (29) sind mit der aktiven Schicht (15,21) elektrisch verbunden und ragen über die Kontaktierungsseite (23) hinaus, um ein direktes Anlöten des Einzelhalbleiterelements an eine Trägerplatine zu ermöglichen. Die Kontaktierungsseite (23) ist mit einer Glaspassivierungsschicht versehen. Alternativ oder zusätzlich hierzu ist wenigstens eine Seitenfläche des Einzelhalbleiterelements mit einer Isolatorschicht versehen, um Kurzschlüsse beim Anlöten des Einzelhalbleiterelements an die Trägerplatine zu vermeiden. Ferner ist es möglich, dass die Lötkontakte (29) an der Kontaktierungsseite (23) unterschiedliche Umrisse aufweisen.

## Beschreibung

Die Erfindung betrifft ein Einzelhalbleiterelement, insbesondere eine Diode oder einen Transistor, in Flip-Chip-Bauweise. Ein derartiges Einzelhalbleiterelement besitzt eine Substratschicht an seiner Rückseite sowie eine aktive Schicht. Die aktive Schicht enthält die elektrisch aktiven Halbleiterkomponenten, und sie ist zwischen der Substratschicht und einer Kontaktierungsseite des Einzelhalbleiterelements angeordnet, die der Rückseite des Einzelhalbleiterelements gegenüberliegt.

Außerdem besitzt ein derartiges Einzelhalbleiterelement mehrere Lötkontakte, die mit der aktiven Schicht elektrisch verbunden sind und über die Kontaktierungsseite des Einzelhalbleiterelements hinausragen, um ein direktes Anlöten des Einzelhalbleiterelements an eine Trägerplatine zu ermöglichen. Bei diesen Lötkontakten handelt es sich um lötfähige Metallkontakte, die insbesondere über eine Zwischenmetallschicht und/oder eine bondfähige Leiterbahn mit einem Anoden- oder Kathodenbereich der aktiven Schicht verbunden sind.

Die Flip-Chip-Bauweise findet herkömmlich in der IC-Technologie Anwendung. Dabei wird ein Chip, der eine Vielzahl von integrierten Halbleiterelementen und eine entsprechend große Anzahl von Lötkontakten besitzt, an einer Trägerplatine befestigt. Hierfür wird der Chip mit seiner Kontaktierungsseite auf die Trägerplatine aufgesetzt und mit dieser direkt verbunden, indem die Lötkontakte des Chip mit der Trägerplatine verlötet werden. Ein solcher Chip ist üblicherweise durch eine dünne, in CVD-Technologie (chemical vapour deposition) erzeugten Oxidschicht geschützt.

Ein Problem bei solchen integrierten Schaltkreisen in Flip-Chip-Bauweise besteht darin, dass an der Kontaktierungsseite eine große Anzahl von vergleichsweise kleinen Lötkontakten sehr eng zueinander angeordnet ist. Um dennoch für alle Lötkontakte einen zuverlässigen elektrischen Kontakt und gleichzeitig einen mechanisch stabilen Sitz des Chip an der Trägerplatine zu gewährleisten, wird die Kontaktierungsseite des Chip mit einem so genannten underfill versehen. Hierbei handelt es sich um eine isolierende Substanz, die unter Ausnutzung des Kapillareffekts zwischen die Lötkontakte gebracht wird.

Dieser herkömmliche Aufbau eines IC-Chip in Flip-Chip-Bauweise ist hinsichtlich der Montage und der Betriebszuverlässigkeit nicht ohne weiteres für ein Einzelhalbleiterelement geeignet, also für ein diskretes Bauelement, wie eine einzelne Diode, eine Mehrfachdiode oder einen einzelnen Transistor.

Es ist deshalb eine Aufgabe der Erfindung, ein Einzelhalbleiterelement zu schaffen, das für eine Flip-Chip-Bauweise bei einem einfachen Aufbau eine hohe Betriebszuverlässigkeit besitzt. Außerdem soll ein entsprechendes Herstellungsverfahren geschaffen werden.

Gemäß einer ersten Ausführungsform der Erfindung wird diese Aufgabe durch ein Einzelhalbleiterelement mit den Merkmalen des Anspruchs 1 gelöst, und insbesondere dadurch, dass die Kontaktierungsseite des Einzelhalbleiterelements mit einer Glaspassivierungsschicht versehen ist, die die Lötkontakte an der Kontaktierungsseite des Einzelhalbleiterelements umfänglich umgibt.

Diese Glaspassivierungsschicht schützt das Einzelhalbleiterelement an der Kontaktierungsseite besonders wirkungsvoll, ohne dass dort eine aufwendige Gehäusewandung erforderlich ist. Die Glaspassivierungsschicht ist von den Lötkontakten durchbrochen, so dass weiterhin ein problemloses Verlöten des Einzelhalbleiterelements an einer Trägerplatine möglich ist.

Die Glaspassivierungsschicht passiviert die Kontaktierungsseite, indem schädliche Stoffe aus der Umgebung abgeblockt oder gebunden werden. Hierfür wird ein Glas verwendet, das selbst wenige oder überhaupt keine Inhaltsstoffe besitzt, die in dem Halbleitersubstrat - beispielsweise durch Eindiffundieren - Schädigungen hervorrufen könnten. Derartige Gläser werden beispielsweise von den Firmen Schott in Landshut (Deutschland) und Viox in Seattle (Washington, USA) hergestellt.

Ein Vorteil einer derartigen Glaspassivierungsschicht an der Kontaktierungsseite des Einzelhalbleiterelements besteht also in einem besonders guten Schutz bei der Handhabung, der Montage und dem Betrieb des Einzelhalbleiterelements. Diese besondere Schutzwirkung ist insbesondere darauf zurückzuführen, dass die Dicke der Glaspassivierungsschicht deutlich größer ist als die Dicke bekannter Schutzschichten. Beispielsweise ist die Dicke der Glaspassivierungsschicht um einen Faktor 5 bis 10 größer als eine übliche Oxidschicht, die in CVD-Technologie aufgebracht wird.

Ein weiterer Vorteil der Glaspassivierungsschicht für den Einsatz bei der Flip-Chip-Bauweise besteht in der mechanischen Stabilisierung des mit einer Trägerplatine verlöteten Einzelhalbleiterelements. Gerade bei Einzelhalbleiterelementen, die im Vergleich zu IC-Chips aufgrund der geringen Anzahl von Lötkontakten zu einem unerwünschten Verkippen an der Trägerplatine neigen, ist ein mechanisch dauerhaft stabiler Sitz an der Trägerplatine schwierig zu realisieren. Die erläuterte Glaspassivierungsschicht trägt aufgrund ihrer vergleichsweise großen Dicke nicht nur zu einem verbesserten Schutz, sondern auch zu einer erhöhten mechanischen Stabilität bei, so dass im Gegensatz zur herkömmlichen Flip-Chip-Bauweise kein zusätzlicher so genannter underfill erforderlich ist.

Ferner besteht ein Vorteil der erläuterten Glaspassivierungsschicht darin, dass diese besonders problemlos an der Kontaktierungsseite eines Einzelhalbleiterelements angebracht werden kann, beispielsweise nach einem so genannten Sedimentationsverfahren. Dies ist darauf zurückzuführen, dass ein Einzelhalbleiterelement eine im Vergleich zu IC-Chips relativ geringe Anzahl von Lötkontakten und einen dementsprechend großen Abstand zwischen den Lötkontakten besitzt.

Bei einem vorteilhaften Verfahren zur Herstellung eines Einzelhalbleiterelements gemäß der erläuterten ersten Ausführungsform wird eine Substratschicht mit einer aktiven Schicht versehen, und danach wird die aktive Schicht mit wenigstens zwei Lötkontakten elektrisch wirksam verbunden, die über eine Kontaktierungsseite des Einzelhalbleiterelements hinausragen. Nach oder noch vor der Erzeugung der Lötkontakte wird die Kontaktierungsseite des Einzelhalbleiterelements in der Umgebung der Lötkontakte mit einer Glaspassivierungsschicht versehen.

Hierfür wird die Kontaktierungsseite mit einer Suspension benetzt, in der Glaspartikel in einer primär alkoholischen Flüssigkeitsmischung weitgehend in der Schwebe gehalten werden. Die Glaspartikel unterliegen also nur schwach der Schwerkraft; sie können jedoch allmählich ohne weiteres Zutun oder durch Zentrifugieren aus der darüber befindlichen Suspensionsschicht gezielt ausgefällt und danach an der Kontaktierungsseite des Einzelhalbleiterelements angetrocknet werden. Anschließend wird die so entstandene Glaspartikelschicht an der Kontaktierungsseite erhitzt bzw. gebrannt, um die gelagerten Glaspartikel zu schmelzen und somit mit dem Einzelhalbleiterelement zu verbinden. Dieses Verfahren zur Erzeugung der Glaspassivierungsschicht wird auch als Sedimentation bezeichnet.

Es ist bevorzugt, wenn die Metallisierungsprozesse, beispielsweise das Anbringen einer Leiterbahn aus Aluminium, das Anbringen einer Zwischenmetallschicht oder das Anbringen eines lötfähigen Metallkontakts, erst nach dem erläuterten Anbringen der Glaspassivierungsschicht durchgeführt werden, da die Metallisierungsprozesse niedrigere Temperaturen erfordern als das erläuterte Glasbrennen.

Es ist von Vorteil, dass die Glaspassivierungsschicht auf einfache Weise strukturiert werden kann, um die Kontaktierungsseite des Einzelhalbleiterelements beispielsweise im Bereich der Lötkontakte oder entlang eines vorgesehenen Trennrasters von der Glaspassivierungsschicht freizuhalten oder nachträglich zu befreien. Insbesondere kann hierfür ein - an sich bekannter - fotolithografischer Prozess vorgesehen sein. Vorzugsweise wird die Glaspassivierungsschicht zunächst - also vor den Metallisierungsprozessen - ganzflächig auf die Kontaktierungsseite aufgebracht und anschließend aufgeschmolzen bzw. gebrannt. Danach wird die Glaspassivierungsschicht fotolithografisch strukturiert, d.h. sie wird an denjenigen Stellen mit Lack abgedeckt, an denen sie erhalten bleiben soll, und der Lack wird an jenen Stellen entfernt, an denen das Glas abgeätzt werden soll. Nach dem Ätzen kann die Metallisierung erfolgen.

Bei diesem Herstellungsverfahren wird die Glaspassivierungsschicht vorzugsweise auf eine Oxidschicht oder auf eine sonstige vergleichsweise dünne Isolatorschicht aufgebracht, die zuvor an der aktiven Schicht des Einzelhalbleiterelements angebracht worden ist. Dies ist jedoch nicht obligatorisch.

Vorzugsweise wird dieses Einzelhalbleiterelement nicht separat, sondern gemeinsam mit einer Vielzahl gleichartiger Einzelhalbleiterelemente auf Grundlage eines gemeinsamen Substrats (wafer) hergestellt. Hierfür wird die jeweilige Kontaktierungsseite der mehreren Halbleiterelemente entlang eines Trennrasters von der Glaspassivierungsschicht freigehalten oder nachträglich von dieser befreit, wie vorstehend bereits erläutert. Anschlieβend werden die Einzelhalbleiterelement vereinzelt, indem sie entlang des Trennrasters auseinandergesägt werden. Somit kann auf an sich bekannte Weise eine Vielzahl von Einzelhalbleiterelementen auf Grundlage eines gemeinsamen Substrats hergestellt werden, wobei die lediglich lokale Anbringung der Glaspassivierungsschicht außerhalb des vorgesehenen Trennrasters gewährleistet, dass während des Zersägens keine mechanischen Spannungen auf die Glaspassivierungsschicht übertragen werden. Hierdurch wird eine Beschädigung der Glaspassivierungsschicht vermieden.

Gemäß einer zweiten Ausführungsform wird die erläuterte Aufgabe durch ein Einzelhalbleiterelement mit den Merkmalen des Anspruchs 7 gelöst, und insbesondere dadurch, dass zur Vermeidung von Kurzschlüssen beim Anlöten des Einzelhalbleiterelements an die Trägerplatine wenigstens eine Seitenfläche des Einzelhalbleiterelements zumindest teilweise mit einer Isolatorschicht versehen ist.

Bei dieser Ausführungsform ist also gewährleistet, dass nach dem Anlöten des Einzelhalbleiterelements an der betreffenden Trägerplatine die nicht isolierten Außenflächen des Einzelhalbleiterelements deutlich von der Trägerplatine oder von dort vorhandenen Lotkugeln beabstandet sind.

Dadurch wird ein Kurzschluss zwischen dem angelöteten Einzelhalbleiterelement und einer Leiterbahn der Trägerplatine besonders wirksam vermieden. Dies ist insbesondere bei kleinen Einzelhalbleiterelementen wichtig, da in einer miniaturisierten Umgebung Kurzschlüsse aufgrund überschüssigen Lots besonders leicht auftreten.

Bei der genannten Isolatorschicht handelt es sich insbesondere um eine Oxidschicht des verwendeten Substrats.

Es ist von Vorteil, wenn zumindest diejenigen Seitenflächen des Einzelhalbleiterelements mit der Isolatorschicht versehen sind, die an einen Lötkontakt jeweils unmittelbar benachbart angrenzen. Vorzugsweise sind jedoch für eine besonders zuverlässige Vermeidung von Kurzschlüssen sämtliche Seitenflächen des Einzelhalbleiterelements mit der Isolatorschicht versehen.

Hinsichtlich der Höhe der Isolatorschicht an der jeweiligen Seitenfläche des Einzelhalbleiterelements kann es bereits ausreichend sein, wenn die betreffende Seitenfläche - ausgehend von der Kontaktierungsseite - zu einem Viertel mit der Isolatorschicht versehen ist. Es ist jedoch bevorzugt, wenn die betreffende Seitenfläche zumindest zu einem an die Kontaktierungsseite angrenzenden Drittel, oder zur Hälfte mit der Isolatorschicht versehen ist. Eine besonders gute Schutzwirkung wird natürlich erreicht, wenn die Seitenfläche des Einzelhalbleiterelements vollständig mit der Isolatorschicht versehen ist.

Es ist besonders bevorzugt, wenn das Einzelhalbleiterelement in einer so genannten Mesa-Bauweise hergestellt ist, mit seitlichen eingeätzten und danach durchgesägten Gräben (so genannten trenches). In diesem Fall kann nach dem Einätzen der Gräben, aber noch vor dem Durchsägen die Isolatorschicht angebracht werden, so dass diese bei dem fertiggestellten Einzelhalbleiterelement die jeweilige Seitenfläche bis zu der Tiefe des ursprünglichen Grabens bedeckt. Auf diese Weise ist auch bei einem effizienten Massenherstellungsprozess eine ausreichende elektrische Isolierung gewährleistet.

Dementsprechend ist bei einem vorteilhaften Verfahren zur Herstellung mehrerer Einzelhalbleiterelemente gemäß der erläuterten zweiten Ausführungsform vorgesehen, dass zunächst ein Substrat mit mehreren seitlich zueinander benachbarten, elektrisch aktiven Bereichen versehen wird. Daraufhin werden entlang eines Rasters zwischen diesen elektrisch aktiven Bereichen Trenngräben in das Substrat eingeätzt. Anschließend wird die Oberfläche des Substrats einschließlich der erzeugten Trenngräben mit einer Isolatorschicht, insbesondere einer Oxidschicht versehen. Dies geschieht vorzugsweise in einem CVD-Verfahren. Schließlich wird das Substrat entlang der Trenngräben zersägt, um eine Vielzahl von Einzelhalbleiterelementen zu erzeugen.

Das erläuterte Verfahren hat den Vorteil, dass eine Vielzahl von Einzelhalbleiterelementen in konventioneller Fertigungstechnologie und somit auf effiziente und kostengünstige Weise hergestellt werden kann, wobei jedes dieser Halbleiterelemente an den Seitenflächen bis zu der Tiefe der ursprünglichen Trenngräben mit der erläuterten Isolatorschicht versehen ist.

Auch bei den Einzelhalbleiterelementen gemäß der zweiten Ausführungsform ist es möglich, dass die aktive Schicht mit wenigstens zwei Lötkontakten elektrisch verbunden wird, die über die Kontaktierungsseite des Einzelhalbleiterelements hinausragen, wobei die Kontaktierungsseite in der Umgebung der Lötkontakte mit einer Glaspassivierungsschicht versehen wird, wie im Zusammenhang mit der ersten Ausführungsform erläutert.

Die erläuterte Aufgabe wird gemäß einer dritten Ausführungsform durch ein Einzelhalbleiterelement mit den Merkmalen des Anspruchs 14 gelöst, und insbesondere dadurch, dass die wenigstens zwei Lötkontakte an der Kontaktierungsseite des Einzelhalbleiterelements unterschiedliche Umrisse aufweisen.

Bei dieser Ausführungsform ist also bezüglich der Erstreckungsebene des Einzelhalbleiterelements an der Kontaktierungsseite eine unterschiedliche laterale Form der beiden Lötkontakte vorgesehen. Hierfür kann eine unterschiedliche Form des jeweiligen Umrisses der Lötkontakte vorgesehen sein. Alternativ oder zusätzlich - also bei gleicher oder unterschiedlicher Form des Umrisses - ist die von den Lötkontakten an der Kontaktierungsseite jeweils eingenommene Fläche unterschiedlich groß.

Diese unterschiedlichen Umrisse ermöglichen eine einfache optische Unterscheidbarkeit der beiden Lötkontakte, so dass die Lage der Anode und die Lage der Kathode nicht leicht verwechselt werden können.

Außerdem kann die unterschiedliche Form oder Größe des jeweiligen Umrisses der Lötkontakte dergestalt gewählt werden, dass die Standstabilität des Einzelhalbleiterelements an der betreffenden Trägerplatine erhöht wird. Dies ist bei Zweipolen von besonderer Bedeutung, da bei einer Befestigung an lediglich zwei Befestigungspunkten generell eine erhöhte Gefahr eines unerwünschten Verkippens besteht.

Es ist bevorzugt, wenn jeder der beiden Lötkontakte an der Kontaktierungsseite des Einzelhalbleiterelements dieselbe Fläche einnimmt. Eine gleiche oder zumindest ähnliche Größe der jeweiligen Fläche der Lötkontakte begünstigt im Hinblick auf die Oberflächenspannung des Lots nämlich eine bessere Verarbeitbarkeit während des Anlötprozesses.

Eine besonders gute Verarbeitbarkeit wird auch dann erzielt, wenn - zusätzlich oder alternativ - jeder der beiden Lötkontakte an der Kontaktierungsseite des Einzelhalbleiterelements dieselbe oder zumindest eine ähnliche Umfangslänge besitzt.

Um die Standstabilität des Einzelhalbleiterelements an der Trägerplatine noch weiter zu erhöhen, kann zusätzlich zu den beiden Lötkontakten wenigstens ein Blindkontakt an der Kontaktierungsseite vorgesehen sein. Bei einem derartigen Blindkontakt handelt es sich um einen Kontakt, der aufgrund des Anlötens des Einzelhalbleiterelements an der Trägerplatine für einen zusätzlichen mechanischen Befestigungspunkt sorgt, ohne selbst elektrisch wirksam zu sein. Ein derartiger Blindkontakt kann in vorteilhafter Weise durch geeignete Anordnung zusätzlich zur optischen Unterscheidbarkeit der elektrisch wirksamen Lötkontakte (Anode und Kathode) beitragen, beispielsweise durch eine asymmetrische Anordnung relativ zu den beiden Lötkontakten.

Alternativ hierzu kann wenigstens einer der beiden elektrisch wirksamen Lötkontakte an der Kontaktierungsseite des Einzelhalbleiterelements mehrteilig ausgebildet sein. Dies bedeutet, dass die mehreren über die Kontaktierungsseite hinausragenden Teile des betreffenden Lötkontakts die gleiche elektrische Funktionalität als Anode oder Kathode besitzen, dabei jedoch an mehreren Stellen über die Kontaktierungsseite hinausragen. Auch hierdurch werden also mehrere mechanische Befestigungspunkte erzeugt, um die Standstabilität des Einzelhalbleiterelements zu erhöhen.

Weiterhin ist es von Vorteil, wenn wenigstens einer der Lötkontakte sich längsförmig entlang einer, mehrerer oder aller Außenkanten der Kontaktierungsseite des Einzelhalbleiterelements erstreckt. Bei einer derartigen Anordnung des Lötkontakts können nämlich mechanische Spannungen besonders gleichmäßig und somit wirkungsvoll aufgefangen werden. Derartige mechanische Spannungen treten insbesondere bei einem Lastwechsel in Betrieb des Einzelhalbleiterelements auf.

Auch das erläuterte Einzelhalbleiterelement gemäß der dritten Ausführungsform kann an der Kontaktierungsseite mit einer Glaspassivierungsschicht versehen werden, wie für die erste Ausführungsform erläutert. Alternativ oder zusätzlich kann das Einzelhalbleiterelement gemäß der dritten Ausführungsform an wenigstens einer Seitenfläche mit einer Isolatorschicht versehen sein, wie im Zusammenhang mit der zweiten Ausführungsform erläutert.

Weitere Weiterbildungen der Erfindung sind in den Unteransprüchen genannt.

Die Erfindung wird nachfolgend beispielhaft unter Bezugnahme auf die Zeichnungen erläutert; in diesen zeigen:
- Fig.: 1 eine schematische Seitenquerschnittsansicht eines Einzelhalbleiterelements gemäß einer ersten Ausführungsform,
- Fig. 2: eine schematische Seitenquerschnittsansicht eines Einzelhalbleiterelements gemäß einer zweiten Ausführungsform, und
- Fig. 3 und 4: jeweils eine schematische Draufsicht der Kontaktierungsseite eines Einzelhalbleiterelements gemäß einer dritten Ausführungsform.

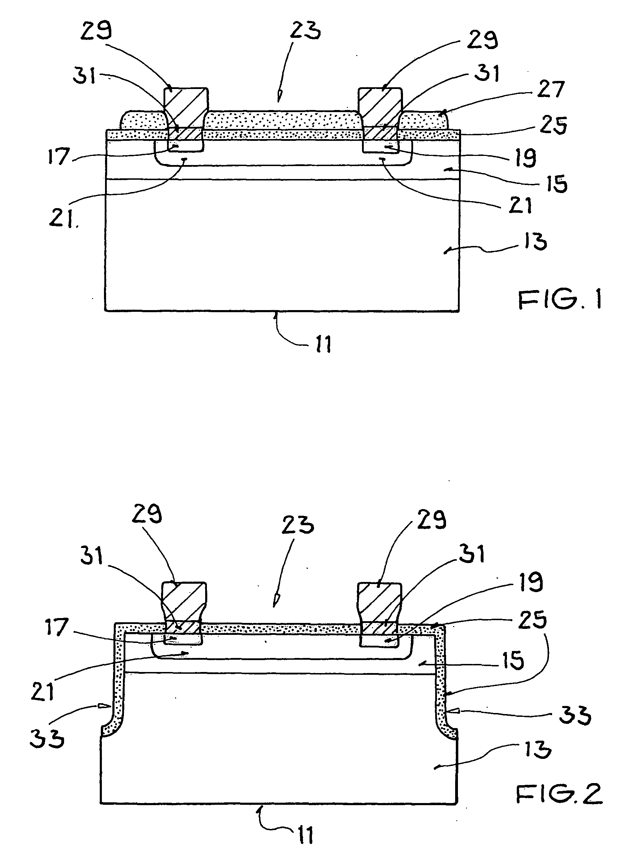

Fig. 1 zeigt ein diskretes Halbleiterbauelement, nämlich eine Diode. Dieses Einzelhalbleiterelement ist zur Befestigung an einer Trägerplatine gemäß der so genannten Flip-Chip-Technologie vorgesehen. Die Trägerplatine ist in den Figuren nicht gezeigt und ist auch nicht Gegenstand der Erfindung.

Das in Fig. 1 gezeigte Einzelhalbleiterelement besitzt ausgehend von einer Rückseite 11 eine Substratschicht 13 aus monokristallinem Silizium. An diese grenzt eine insbesondere epitaktisch aufgewachsene aktive Schicht 15 an. Innerhalb der aktiven Schicht 15 sind eine Kathode 17 und eine Anode 19 mit unterschiedlicher Dotierung ausgebildet. Diese sind innerhalb eines elektrisch aktiven Bereichs 21 der aktiven Schicht 15 eingebettet.

Die der Rückseite 11 gegenüberliegende Seite des Einzelhalbleiterelements ist als eine Kontaktierungsseite 23 ausgebildet. An dieser Kontaktierungsseite 23 ist die aktive Schicht 15 von einer optionalen Oxidschicht 25 bedeckt, die beispielsweise nach einem CVD-Verfahren abgeschieden worden ist. Hieran angrenzend ist die Kontaktierungsseite 23 durch eine Glaspassivierungsschicht 27 abgeschlossen. Diese ist vorzugsweise nach dem bereits erläuterten Sedimentationsverfahren erzeugt, und sie kann um einen Faktor zwischen 5 und 10 dicker sein als die Oxidschicht 25.

Im Bereich der Kathode 17 und der Anode 19 sind die Oxidschicht 25 und die Glaspassivierungsschicht 27 für einen jeweiligen Lötkontakt 29 durchbrochen. Bei den Lötkontakten 29 handelt es sich um lötfähige Metallkontakte, die über eine jeweilige Zwischenmetallschicht 31 mit der Kathode 17 bzw. der Anode 19 elektrisch wirksam verbunden sind. Die Zwischenmetallschichten 31 verbessern die elektrische und mechanische Verbindung. Die Lötkontakte 29 ragen über die Kontaktierungsseite 23 des gezeigten Einzelhalbleiterelements hinaus, und zwar in gleicher Höhe.

Das gezeigte Einzelhalbleiterelement besitzt innerhalb des elektrisch aktiven Bereichs 21 eine an sich bekannte elektrische Funktionalität, hier als Diode. Eine Besonderheit besteht jedoch bereits darin, dass diese Diode als diskretes Bauelement für eine Flip-Chip-Montage an einer Trägerplatine vorgesehen ist. Hierfür wird das Einzelhalbleiterelement - ausgehend von der Lage gemäß Fig. 1 - umgedreht und mit nach unten weisender Kontaktierungsseite 23 von oben auf die betreffende Trägerplatine aufgesetzt, so dass die überstehenden Lötkontakte 29 an entsprechenden Kontaktierungsstellen der Trägerplatine anliegen. Durch Erhitzen der Lötkontakte 29 wird eine Lötverbindung mit der Trägerplatine hergestellt, so dass gleichzeitig eine elektrische und eine mechanische Verbindung erzeugt werden.

Das Einzelhalbleiterelement gemäß Fig. 1 zeichnet sich besonders durch die Glaspassivierungsschicht 27 aus, die die Kontaktierungsseite 23 flächig bedeckt und dabei die Lötkontakte 29 umfänglich umgibt. Diese Glaspassivierungsschicht 27 sorgt für einen wirksamen mechanischen Schutz der Kontaktierungsseite 23 während der Handhabung und Bearbeitung des noch vereinzelten Bauelements.

Außerdem vereinfacht die Glaspassivierungsschicht 27 die erläuterte Anbringung des Einzelhalbleiterelements an einer Trägerplatine, da dieses Einzelhalbleiterelement mit der Glaspassivierungsschicht 27 ohne weiteres an der Trägerplatine anliegen kann, ohne dass die Gefahr einer mechanischen Beschädigung, des Eindiffundierens schädlicher Substanzen oder der Erzeugung von elektrischen Kurzschlüssen besteht. Gleichzeitig begünstigt die Glaspassivierungsschicht 27 die mechanische Standstabilität des an der Trägerplatine verlöteten Bauelements, so dass keine zusätzlichen mechanischen Unterstützungsmaßnahmen erforderlich sind.

Wie in Fig. 1 gezeigt, kann die Glaspassivierungsschicht 27 auch an den Außenkanten der Kontaktierungsseite 23 des Einzelhalbleiterelements unterbrochen sein. Dies ist von besonderem Vorteil, wenn an einem einzigen Substrat eine Vielzahl von gleichartigen Einzelhalbleiterelementen mit jeweils einer Glaspassivierungsschicht 27 erzeugt wird, die durch Zersägen des Substrats vereinzelt werden. Wenn nämlich - wie in Fig. 1 gezeigt - entlang des für das Zersägen vorgesehenen Trennrasters die Glaspassivierung unterbrochen ist, so führt dieses Zersägen nicht zu unerwünschten mechanischen Spannungen an der jeweiligen Glaspassierungsschicht 27.

Fig. 2 zeigt ein Einzelhalbleiterelement gemäß einer zweiten Ausführungsform. Dieses besitzt einen ähnlichen Aufbau wie die Flip-Chip-Diode gemäß Fig. 1. Ausgehend von einer Rückseite 11 des in Fig. 2 gezeigten Einzelhalbleiterelements erstrecken sich eine Substratschicht 13 und - hieran angrenzend - eine aktive Schicht 15 mit einem elektrisch aktiven Bereich 21, innerhalb dessen eine Kathode 17 und eine Anode 19 ausgebildet sind. An einer Kontaktierungsseite 23 des Einzelhalbleiterelements sind die Kathode 17 und die Anode 19 jeweils mit einer Zwischenmetallschicht 31 versehen, an denen jeweils ein Lötkontakt 29 angebracht ist. Die Lötkontakte 29 stehen - in gleicher Höhe - über die ansonsten flächige Kontaktierungsseite 23 über.

Das in Fig. 2 gezeigte Einzelhalbleiterelement ist in einer so genannten Mesa-Bauweise hergestellt, mit Ausnehmungen 33 an den Seitenflächen des Einzelhalbleiterelements. Diese Ausnehmungen 33 resultieren aus eingeätzten V-förmigen Gräben, wie nachfolgend noch erläutert wird. Die Ausnehmungen 33 erstrecken sich ausgehend von der Kontaktierungsseite 23 in Richtung der Rückseite 11 über die Hälfte der Dicke des Einzelhalbleiterelements hinaus.

Eine Besonderheit des in Fig. 2 gezeigten Einzelhalbleiterelements besteht darin, dass es mit einer Oxidschicht 25 versehen ist, die,nicht nur - mit Durchbrechungen für die Lötkontakte 29 - die Kontaktierungsseite 23 flächig bedeckt. Sondern diese Oxidschicht 25 bedeckt auch die seitlichen Ausnehmungen 33 bis zu deren Tiefe.

Auch das Einzelhalbleiterelement gemäß Fig. 2 besitzt eine übliche elektrische Funktionalität, beispielsweise als Diode oder - falls ein zusätzlicher elektrisch wirksamer Lötkontakt 29 vorgesehen ist - als Transistor. Auch dieses diskrete Bauelement ist für eine Flip-Chip-Verbindung mit einer Trägerplatine vorgesehen, wie bereits im Zusammenhang mit Fig. 1 erläutert.

Ein besonderer Vorteil des Einzelhalbleiterelements gemäß Fig. 2 besteht darin, dass die Oxidschicht 25 sich entlang der Ausnehmungen 33 und somit entlang eines Großteils der jeweiligen Seitenfläche erstreckt. Sobald das gezeigte Einzelhalbleiterelement mit seiner Kontaktierungsseite 23 an einer Trägerplatine verlötet worden ist, sorgt die Oxidschicht 25 dafür, dass es nicht leicht aufgrund überschüssigen Lots zu elektrischen Kurzschlüssen zwischen dem Einzelhalbleiterelement und der Trägerplatine kommt. Hierbei ist es von besonderem Vorteil, dass die Oxidschicht 25 sich ausgehend von der Kontaktierungsseite 23 durchgehend bis zu den Ausnehmungen 33 bzw. der entsprechenden Seitenflächen erstreckt. Dadurch ist nämlich ein Mindestabstand der nicht isolierten Bereiche des Einzelhalbleiterelements von der Trägerplatine gewährleistet.

Ein weiterer Vorteil besteht darin, dass diese zusätzliche seitliche Isolierung ohne großen Zusatzaufwand im Rahmen eines üblichen Herstellungsprozesses erzeugt werden kann. Ausgehend von einem gemeinsamen Substrat kann nämlich eine Vielzahl von gleichartigen Einzelhalbleiterelementen dadurch erzeugt werden, dass entlang eines vorbestimmten Anordnungsmusters die jeweilige aktive Schicht 15 mit einer Kathode 17 und einer Anode 19 innerhalb eines elektrisch aktiven Bereichs 21 erzeugt wird. Das Substrat wird entlang eines Rasters mit Trenngräben versehen, die zwischen den jeweiligen elektrisch aktiven Bereichen 21 verlaufen und in das Substrat beispielsweise eingeätzt werden. Anschließend wird die Substratoberfläche einschließlich der daran erzeugten Trenngräben mit der Oxidschicht 25 versehen. Danach wird das Substrat entlang der Trenngräben zersägt.

Auf diese Weise wird eine Vielzahl von Einzelhalbleiterelementen erzeugt, die an den Seitenflächen entlang des Verlaufs der ursprünglichen Trenngräben mit einer Oxidschicht 25 versehen sind, wie in Fig. 2 gezeigt.

Zu dem Einzelhalbleiterelement gemäß Fig. 2 ist noch anzumerken, dass es bei einem quadratischen oder rechteckigen Umriss auch an allen vier Seitenflächen mit der erläuterten Oxidschicht 25 versehen sein kann, insbesondere aufgrund eines umfänglichen Verlaufs der eingeätzten Trenngräben bei dem erläuterten Herstellungsverfahren.

Außerdem kann dieses Einzelhalbleiterelement zusätzlich an der Kontaktierungsseite 23 mit einer Glaspassivierungsschicht 27 versehen sein, wie im Zusammenhang mit Fig. 1 erläutert. Es ist prinzipiell sogar möglich, dass anstelle der in Fig. 2 gezeigten Oxidschicht 25 eine Glaspassivierungsschicht angebracht wird, die sich auch entlang der Ausnehmungen 33 erstreckt.

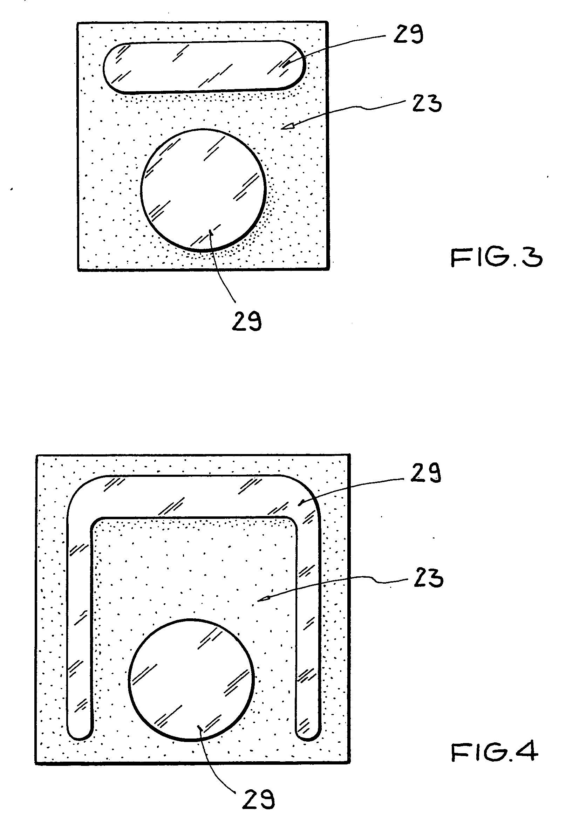

Fig. 3 und 4 zeigen die Kontaktierungsseite 23 einer dritten Ausführungsform eines jeweiligen Flip-Chip-Einzelhalbleiterelements. Dieses Einzelhalbleiterelement kann einen üblichen Aufbau besitzen, wie im Zusammenhang mit Fig. 1 und 2 erläutert, mit einer rückseitigen Substratschicht 13, einer aktiven Schicht 15 mit darin ausgebildeter Kathode 17 und Anode 19, sowie mit einer Schutzschicht, insbesondere einer Oxidschicht 25 an der Kontaktierungsseite 23 und mit hierüber hinausragenden Lötkontakten 29. Es ist von besonderem Vorteil, wenn das Einzelhalbleiterelement gemäß Fig. 3 oder gemäß Fig. 4 zusätzlich mit einer Glaspassivierungsschicht 27 gemäß Fig. 1 und/oder einer seitlichen Oxidschicht 25 gemäß Fig. 2 versehen ist.

Eine Besonderheit des Einzelhalbleiterelements gemäß Fig. 3 besteht darin, dass die beiden Lötkontakte 29 eine unterschiedliche Form des jeweiligen Umrisses besitzen. Der eine Lötkontakt 29 besitzt einen kreisförmigen Umriss, während der Umriss des anderen der beiden Lötkontakte 29 eine Längsform aufweist. Aufgrund dieser unterschiedlichen Formgebung können die beiden Lötkontakte 29 ohne weiteres optisch voneinander unterschieden werden, so dass bei bekannter Zuordnung der Anode und der Kathode des Bauelements zu den Lötkontakten 29 die Anode und die Kathode beim Verlöten des Bauelements mit einer Trägerplatine nicht leicht verwechselt werden können.

Ein weiterer Vorteil des Einzelhalbleiterelements gemäß Fig. 3 besteht darin, dass die beiden Lötkontakte 29 an der Kontaktierungsseite 23 jeweils ungefähr dieselbe Fläche einnehmen und dort auch jeweils ungefähr dieselbe Umfangslänge besitzen. Ein ähnliches Ausmaß der an der Kontaktierungsseite 23 eingenommenen Fläche verbessert die Verarbeitbarkeit des Einzelhalbleiterelements beim Anlöten an eine Trägerplatine gegenüber störenden Effekten, die aus der Oberflächenspannung des Lots resultieren können. Auch die ähnlichen Längen des jeweils eingenommenen Umfangs der Lötkontakte 29 gemäß Fig. 3 vereinfachen das Befestigen des Einzelhalbleiterelements an einer Trägerplatine im Rahmen eines Lötvorgangs.

Ein weiterer Vorteil dieses Ausführungsbeispiels besteht darin, dass die beiden Lötkontakte 29 - beispielsweise gegenüber zwei im Wesentlichen punktförmigen Kontakten - einen vergleichsweise großen Flächenanteil an der Kontaktierungsseite 23 einnehmen. Hierdurch ist ein stabiler Sitz des angelöteten Einzelhalbleiterelements an der Trägerplatine gewährleistet.

Schließlich trägt auch die längliche Ausgestaltung des einen Lötkontakts 29 senkrecht zu der Anordnungsrichtung der beiden Lötkontakte 29 zu einem stabilen Sitz des Einzelhalbleiterelements an der Trägerplatine bei, da hierdurch ein Verkippen senkrecht zu der Anordnungsrichtung der beiden Lötkontakte 29 ausgeschlossen ist.

Bei dem Einzelhalbleiterelement gemäß Fig. 4 besitzt einer der beiden Lötkontakte 29 einen U-förmigen Umriss und erstreckt sich dabei entlang von drei Außenkanten der Kontaktierungsseite 23 des gezeigten Einzelhalbleiterelements. Der andere der beiden Lötkontakte 29 besitzt einen kreisförmigen Umriss und ist innerhalb dieser U-Form angeordnet.

Der gezeigte Verlauf des einen Lötkontakts 29 entlang mehrerer Außenkanten der Kontaktierungsseite 23 bewirkt ein gutes Abfedern von möglichen Dehnungseffekten, die insbesondere bei einem Lastwechsel im Betrieb des Einzelhalbleiterelements auftreten können.

Außerdem sind die beiden Lötkontakte 29 aufgrund der sehr unterschiedlichen Formgebung ihres jeweiligen Umrisses besonders gut optisch voneinander unterscheidbar, um hierdurch die Kathode bzw. die Anode kennzeichnen zu können.

Alternativ zu der U-Form des einen Lötkontakts 29 gemäß Fig. 4 kann dessen Umriss auch zu einer C-Form abgerundet sein. Auch der andere Lötkontakt 29 gemäß Fig. 4 muss nicht unbedingt kreisrund sein, sondern kann beispielsweise auch quadratisch, rechteckig oder T-förmig sein, wobei der Querbalken der T-Form sich entlang der vierten Außenkante der Kontaktierungsseite 23 erstreckt.

Zu sämtlichen der gezeigten Ausführungsformen ist noch anzumerken, dass die erläuterten Einzelhalbleiterelemente - als diskrete Diode - jeweils genau zwei oder - als diskreter Transistor - genau drei elektrisch wirksame Lötkontakte 29 aufweisen können. Ferner können die Lötkontakte 29 optional einen unschmelzbaren Kern aufweisen, der bei der Befestigung des jeweiligen Einzelhalbleiterelements an einer Trägerplatine als Distanzstück dient.

### Bezugszeichenliste

- 11: Rückseite
- 13: Substratschicht
- 15: aktive Schicht
- 17: Kathode
- 19: Anode
- 21: elektrisch aktiver Bereich
- 23: Kontaktierungsseite
- 25: Oxidschicht
- 27: Glaspassivierungsschicht
- 29: Lötkontakt
- 31: Zwischenmetallschicht
- 33: Ausnehmung

## Patentansprüche

1. Einzelhalbleiterelement, insbesondere Diode oder Transistor, in Flip-Chip-Bauweise, zumindest mit
- einer Substratschicht (13) an einer Rückseite (11) des Einzelhalbleiterelements,
- einer aktiven Schicht (15, 21), die zwischen der Substratschicht und einer der Rückseite gegenüberliegenden Kontaktierungsseite (23) des Einzelhalbleiterelements angeordnet ist, und
- wenigstens zwei Lötkontakten (29), die mit der aktiven Schicht elektrisch verbunden sind und über die Kontaktierungsseite (23) des Einzelhalbleiterelements hinausragen, um ein direktes Anlöten des Einzelhalbleiterelements an eine Trägerplatine zu ermöglichen,
wobei die Kontaktierungsseite (23) mit einer Glaspassivierungsschicht (27) versehen ist, die die Lötkontakte (29) umfänglich umgibt.

2. Einzelhalbleiterelement nach Anspruch 1,
**dadurch gekennzeichnet,**
**dass** die Glaspassivierungsschicht (27) im Bereich der Lötkontakte (29) und im Bereich eines Trennrasters zwischen benachbart hergestellten Einzelhalbleiterelementen unterbrochen ist.

3. Einzelhalbleiterelement nach einem der vorhergehenden Ansprüche,
**dadurch gekennzeichnet,**
**dass** zwischen der Glaspassivierungsschicht (27) und der aktiven Schicht (15, 21) eine Oxidschicht (25) vorgesehen ist.

4. Einzelhalbleiterelement nach einem der vorhergehenden Ansprüche,
**dadurch gekennzeichnet,**
**dass** die Lötkontakte (29) mit der aktiven Schicht (15, 21) über eine Zwischenmetallschicht (31) verbunden sind.

5. Verfahren zur Herstellung eines Einzelhalbleiterelements nach einem der vorhergehenden Ansprüche, bei dem
- eine Substratschicht (13) mit einer aktiven Schicht (15, 21) versehen wird,
- die aktive Schicht mit wenigstens zwei Lötkontakten (29) elektrisch verbunden wird, die über eine Kontaktierungsseite (23) des Einzelhalbleiterelements hinausragen, und
- die Kontaktierungsseite (23) des Einzelhalbleiterelements in der Umgebung der Lötkontakte (29) vor oder nach Erzeugung der Lötkontakte mit einer Glaspassivierungsschicht (27) versehen wird, indem
- die Kontaktierungsseite (23) mit einer Suspension benetzt wird, so dass darin enthaltene Glaspartikel aufgrund der Schwerkraft oder einer Zentrifugalkraft an der Kontaktierungsseite abgelagert werden, und
- die Kontaktierungsseite (23) anschließend erhitzt wird, um die abgelagerten Glaspartikel zu schmelzen.

6. Verfahren nach Anspruch 5,
**dadurch gekennzeichnet,**
**dass** die Kontaktierungsseite (23) des Einzelhalbleiterelements zunächst ganzflächig mit der Glaspassivierungsschicht (27) versehen wird und die Glaspassivierungsschicht danach fotolithografisch strukturiert wird, wobei die Kontaktierungsseite (23) insbesondere im Bereich der Lötkontakte (29) von der Glaspassivierungsschicht (27) befreit wird, und/oder
**dass** das Einzelhalbleiterelement gemeinsam mit mehreren anderen Einzelhalbleiterelementen auf Grundlage eines gemeinsamen Substrats hergestellt wird, wobei
- die Kontaktierungsseiten (23) der Einzelhalbleiterelemente entlang eines Trennrasters von der Glaspassivierungsschicht (27) freigehalten oder befreit werden, und
- die Einzelhalbleiterelemente entlang des Trennrasters auseinandergesägt werden.

7. Einzelhalbleiterelement, insbesondere Diode oder Transistor, in Flip-Chip-Bauweise,
insbesondere nach einem der Ansprüche 1 bis 4,
zumindest mit
- einer Substratschicht (13) an einer Rückseite (11) des Einzelhalbleiterelements,
- einer aktiven Schicht (15, 21), die zwischen der Substratschicht und einer der Rückseite gegenüberliegenden Kontaktierungsseite (23) des Einzelhalbleiterelements angeordnet ist, und
- wenigstens zwei Lötkontakten (29), die mit der aktiven Schicht elektrisch verbunden sind und über die Kontaktierungsseite (23) des Einzelhalbleiterelements hinausragen, um ein direktes Anlöten des Einzelhalbleiterelements an eine Trägerplatine zu ermöglichen,
wobei zur Vermeidung von Kurzschlüssen beim Anlöten des Einzelhalbleiterelements an die Trägerplatine wenigstens eine Seitenfläche (33) des Einzelhalbleiterelements zumindest teilweise mit einer Isolatorschicht (25) versehen ist.

8. Einzelhalbleiterelement nach Anspruch 7,
**dadurch gekennzeichnet,**
**dass** die Seitenfläche (33) des Einzelhalbleiterelements zumindest zu einem an die Kontaktierungsseite (23) angrenzenden Viertel, insbesondere zu einem Drittel, vorzugsweise zur Hälfte mit der Isolatorschicht (25) versehen ist, oder
**dass** die Seitenfläche des Einzelhalbleiterelements vollständig mit der Isolatorschicht (25) versehen ist.

9. Einzelhalbleiterelement nach Anspruch 7 oder 8,
**dadurch gekennzeichnet,**
**dass** das Einzelhalbleiterelement eine Mesa-Bauweise mit seitlichen eingeätzten und durchgesägten Gräben (33) aufweist, wobei die jeweilige Seitenfläche bis zu der Tiefe des jeweiligen Grabens mit der Isolatorschicht (25) versehen ist.

10. Einzelhalbleiterelement nach einem der Ansprüche 7 bis 9,
**dadurch gekennzeichnet,**
**dass** wenigstens die an einen Lötkontakt (29) jeweils unmittelbar angrenzenden Seitenflächen (33) des Einzelhalbleiterelements mit der Isolatorschicht (25) versehen sind,
wobei insbesondere alle Seitenflächen des Einzelhalbleiterelements mit der Isolatorschicht (25) versehen sind.

11. Einzelhalbleiterelement nach einem der Ansprüche 7 bis 10,
**dadurch gekennzeichnet,**
**dass** auch die Kontaktierungsseite (23) mit der Isolatorschicht (25) versehen ist, und/oder
**dass** es sich bei der Isolatorschicht um eine Oxidschicht (25) handelt.

12. Verfahren zur Herstellung mehrerer Einzelhalbleiterelemente nach einem der Ansprüche 7 bis 11, bei dem
- ein Substrat (13) zur Vorbereitung mehrerer benachbarter Einzelhalbleiterelemente mit einer jeweiligen aktiven Schicht (15, 21) und mit dazwischen liegenden Trenngräben (33) versehen wird,
- die aktiven Schichten (15, 21) und die dazwischen liegenden Trenngräben (33) mit einer Isolatorschicht (25) versehen werden, und
- die benachbarten Einzelhalbleiterelemente entlang der Trenngräben (33) auseinandergesägt werden.

13. Verfahren nach Anspruch 12,
**dadurch gekennzeichnet,**
**dass** es sich bei der Isolatorschicht um eine Oxidschicht (25) handelt, und/oder
**dass** die Isolatorschicht (25) in einem CVD-Verfahren aufgebracht wird.

14. Einzelhalbleiterelement, insbesondere Diode oder Transistor, in Flip-Chip-Bauweise,
insbesondere nach einem der Ansprüche 1 bis 4 oder 7 bis 11, zumindest mit
- einer Substratschicht (13) an einer Rückseite (11) des Einzelhalbleiterelements,
- einer aktiven Schicht (15, 21), die zwischen der Substratschicht und einer der Rückseite gegenüberliegenden Kontaktierungsseite (23) des Einzelhalbleiterelements angeordnet ist, und
- wenigstens zwei Lötkontakten (29), die mit der aktiven Schicht elektrisch verbunden sind und über die Kontaktierungsseite (23) des Einzelhalbleiterelements hinausragen, um ein direktes Anlöten des Einzelhalbleiterelements an eine Trägerplatine zu ermöglichen,
wobei die Lötkontakte (29) an der Kontaktierungsseite (23) des Einzelhalbleiterelements unterschiedliche Umrisse aufweisen.

15. Einzelhalbleiterelement nach Anspruch 14,
**dadurch gekennzeichnet ,**
**dass** die Form des jeweiligen Umrisses der beiden Lötkontakte (29) unterschiedlich ist, und/oder
**dass** jeder der beiden Lötkontakte (29) an der Kontaktierungsseite (23) dieselbe Fläche einnimmt, und/oder
**dass** jeder der beiden Lötkontakte (29) an der Kontaktierungsseite (23) dieselbe Umfangslänge besitzt.

16. Einzelhalbleiterelement nach Anspruch 14,
**dadurch gekennzeichnet,**
**dass** bei gleicher Form des jeweiligen Umrisses die an der Kontaktierungsseite (23) jeweils eingenommene Fläche der beiden Lötkontakte (29) unterschiedlich ist.

17. Einzelhalbleiterelement nach einem der Ansprüche 14 bis 16,
**dadurch gekennzeichnet,**
**dass** zusätzlich zu den beiden Lötkontakten (29) wenigstens ein Blindkontakt zur Erhöhung der Standstabilität vorgesehen ist, oder
**dass** wenigstens einer der beiden Lötkontakte (29) an der Kontaktierungsseite (23) des Einzelhalbleiterelements mehrteilig ausgebildet ist.

18. Einzelhalbleiterelement nach einem Ansprüche 14 bis 17,
**dadurch gekennzeichnet,**
**dass** wenigstens einer der beiden Lötkontakte (29) sich entlang wenigstens einer, vorzugsweise entlang von zwei oder drei Außenkanten der Kontaktierungsseite (23) des Einzelhalbleiterelements erstreckt.

19. Einzelhalbleiterelement nach einem Ansprüche 14 bis 18,
**dadurch gekennzeichnet,**
**dass** einer der beiden Lötkontakte (29) einen kreisförmigen Umriss und der andere der beiden Lötkontakte (29) einen länglichen Umriss besitzt, und
**dass** die beiden Lötkontakte an der Kontaktierungsseite (23) jeweils dieselbe Fläche einnehmen oder jeweils dieselbe Umfangslänge besitzen.

20. Einzelhalbleiterelement nach einem Ansprüche 14 bis 18,
**dadurch gekennzeichnet,**
**dass** einer der beiden Lötkontakte (29) einen U-förmigen oder C-förmigen Umriss besitzt und sich entlang von drei Außenkanten der Kontaktierungsseite (23) des Einzelhalbleiterelements erstreckt, und
**dass** der andere der beiden Lötkontakte (29) zumindest teilweise innerhalb der U- bzw. C-Form des einen Lötkontakts eingeschlossen ist.
